(19) Europäisches Patentamt
European Patent Office
Office européen des brevets

(11) EP 2 243 755 A1

(12) **EUROPEAN PATENT APPLICATION**
published in accordance with Art. 153(4) EPC

(43) Date of publication:
27.10.2010 Bulletin 2010/43

(51) Int Cl.:
*C04B 35/00* (2006.01)     *H01L 35/22* (2006.01)
*H01L 35/34* (2006.01)

(21) Application number: 09710084.6

(22) Date of filing: 04.02.2009

(86) International application number:
PCT/JP2009/052242

(87) International publication number:
WO 2009/101946 (20.08.2009 Gazette 2009/34)

(84) Designated Contracting States:
AT BE BG CH CY CZ DE DK EE ES FI FR GB GR
HR HU IE IS IT LI LT LU LV MC MK MT NL NO PL
PT RO SE SI SK TR
Designated Extension States:
AL BA RS

(30) Priority: 14.02.2008  JP 2008032760
10.04.2008  JP 2008102180

(71) Applicant: **Sumitomo Chemical Company, Limited**
**Tokyo 104-8260 (JP)**

(72) Inventor: **SADAOKA, Kazuo**
**Toyonaka-shi**
**Osaka 561-0802 (JP)**

(74) Representative: **Hart-Davis, Jason et al**
**Cabinet Beau de Loménie**
**158, rue de l'Université**
**75340 Paris Cedex 07 (FR)**

(54) **METHOD FOR PRODUCING SINTERED BODY**

(57)     Disclosed is a production method of a sintered body. The production method of a sintered body comprises a step of sintering, at a temperature within the range of from 900°C to 1200°C, a mixture of a manganese-based oxide and copper oxide wherein the ratio of the molar amount of copper to one mol of manganese in the mixture is in the range of from 0.001 to 0.05.

**Description**

TECHNICAL FIELD

The present invention relates to a production method of a sintered body. More particularly, the present invention relates to a production method of a sintered body containing a manganese-based oxide.

BACKGROUND ART

Sintered bodies containing a manganese-based oxide are utilized in various fields such as magnetic materials, solid oxides for fuel cells and thermoelectric conversion materials.

A manganese-based oxide includes $CaMnO_3$. JP-A No. 2003-142742 (p. 2-3, Examples) discloses to use this as a thermoelectric conversion material and specifically discloses that starting materials are blended so as to provide a predetermined composition, calcined, pulverized, molded, and sintered in atmospheric air at 1550°C to yield a sintered body of a manganese-based oxide.

DISCLOSURE OF THE INVENTION

However, the sintered body obtained above has a problem that cracks are generated in the sintered body when applying pressure such as processing thereof, that is, mechanical strength thereof is not sufficient. The present invention has an object of providing a production method of a sintered body excellent in mechanical strength, as compared with sintered bodies of a conventional manganese-based oxide.

The present inventors have variously investigated and resultantly completed the present invention. That is, the present invention provides the following inventions.

<1> A production method of a sintered body, comprising a step of sintering, at a temperature within the range of from 900°C to 1200°C, a mixture of a manganese-based oxide and copper oxide wherein the ratio of the molar amount of copper to one mol of manganese in the mixture is in the range of from 0.001 to 0.05.

<2> The production method according to <1>, wherein the sintering is performed after molding of the mixture.

<3> The production method according to <1> or <2>, wherein the manganese-based oxide has a perovskite type crystal structure or a layered perovskite type crystal structure.

<4> The production method according to any one of <1> to <3>, wherein the manganese-based oxide is a calcium manganese oxide.

<5> The production method according to any one of <1> to <4>, wherein the sintered body is a sintered body to be used as a thermoelectric conversion material.

MODE FOR CARRYING OUT THE INVENTION

The production method of a sintered body of the present invention comprises a step of sintering, at a temperature within the range of from 900°C to 1200°C, a mixture of a manganese-based oxide and copper oxide wherein the ratio of the molar amount of copper to one mol of manganese in the mixture is in the range of 0.001 to 0.05.

The manganese-based oxide means an oxide containing manganese, and the manganese-based oxide includes an oxide represented by $AMnO_3$ (here, A represents one or more elements selected from the group consisting of Ca, Sr, Ba, La, Y and lanthanoid), $Ca_{n+1}Mn_nO_{3n+1}$ (here, n represents an integer of from 1 to 10), $CaMn_7O_{12}$, $Mn_3O_4$, $MnO_2$ or $CuMnO_2$, and it is preferable that the manganese-based oxide have a perovskite type crystal structure or a layered perovskite type crystal structure for further enhancing a thermoelectric converting property as a thermoelectric conversion material. The manganese-based oxide is preferably a calcium manganese oxide further containing calcium.

The manganese-based oxide having a perovskite type crystal structure specifically includes an oxide represented by $CaMnO_3$ (here, Ca and/or Mn may be partially substituted by heterogeneous elements), and the heterogeneous element for partially substituting Ca includes one or more elements selected from among Mg, Sr, Ba, Sc, Y, La, Ce, Pr, Nd, Sm, Eu, Gd, Tb, Dy, Ho, Er, Tm, Yb, Lu, Bi, Sn, In and Pb, and the said one or more elements preferably contain one or more elements selected from among Mg, Sr and Ba. The heterogeneous element for partially substituting Mn includes one or more elements selected from among V, Ru, Nb, Mo, W and Ta. When Ca and/or Mn of an oxide represented by $CaMnO_3$ is partially substituted by heterogeneous elements, as described above, a thermoelectric converting property in the case of use of the resultant sintered body as a thermoelectric conversion material may be further enhanced in some cases.

The manganese-based oxide having a layered perovskite type crystal structure specifically includes an oxide represented by the formula (1).

$$Ca_{n+1}Mn_nO_{3n+1} \qquad (1)$$

(here, n represents an integer of from 1 to 10, and Ca and/or Mn may be partially substituted by heterogeneous elements).

The heterogeneous element for partially substituting Ca in the formula (1) includes one or more elements selected from among Mg, Sr, Ba, Sc, Y, La, Ce, Pr, Nd, Sm, Eu, Gd, Tb, Dy, Ho, Er, Tm, Yb, Lu, Bi, Sn, In and Pb, and the said one or more elements preferably contain one or more elements selected from among Mg, Sr and Ba. The heterogeneous element for partially substituting Mn includes one or more elements selected from among V, Ru, Nb, Mo, W and Ta. When Ca and/or Mn of an oxide represented by the formula (1) is partially substituted by heterogeneous elements, as described above, a thermoelectric converting property in the case of use of the resultant sintered body as a thermoelectric conversion material may be further enhanced in some cases.

In the mixture of a manganese-based oxide and copper oxide, the ratio of the molar amount of copper to one mol of manganese is in the range of from 0.001 to 0.05. The powder properties (average particle size, specific surface area) of each of the manganese-based oxide and copper oxide may be appropriately set.

The relative density of the resultant sintered body is preferably 80% or more, more preferably 90% or more. The sintered body can be used in a shape suitable for each application, such as plate, circular cylinder and rectangular cylinder. The relative density is determined by the following formula where the molecular weight of a manganese-based oxide in a sintered body is represented by $\alpha$, the theoretical density of a manganese-based oxide is represented by A (g/cm$^3$), the molecular weight of copper oxide is 79.55, the theoretical density of copper oxide is 6.32(g/cm$^3$), the actually measured density of a sintered body is represented by C(g/cm$^3$) and the ratio of copper oxide to a sintered body is represented by x (mol%).

$$\text{Relative density (\%)} = C/[\{\alpha \times (100-x) + 79.55 \times x\}/\{\alpha \times (100-x)/A + 79.55 \times x/6.32\}] \times 100$$

Next, the production method of the present invention will be illustrated further in detail.

The manganese-based oxide can be produced by calcining a metal compound mixture which can become the manganese-based oxide by calcination. Specifically, compounds containing constituent metal elements are weighed and mixed so as to provide a predetermined composition, and the resultant metal compound mixture is calcined, whereby the manganese-based oxide can be produced.

As the above-described compound containing metal elements, for example, an oxide is used, alternatively, a compound capable of becoming a oxide when decomposed and/or oxidized at high temperatures, such as a hydroxide, a carbonate, a nitrate, a halide, a sulfate and an organic acid salt is used. Instead of the compound, a metal containing the above-described metal elements may be used.

In the case of use of CaMnO$_3$ as the manganese-based oxide, constituent metal elements are Ca and Mn, and the compound containing Ca includes a carbonate, a sulfate, a hydroxide and the like, and a carbonate is preferably used. The compound containing Mn includes manganese monoxide, manganese dioxide, dimanganese trioxide, trimanganese tetraoxide, manganese nitrate, manganese acetate and the like, and manganese dioxide is preferably used.

Mixing of the above-described compounds containing metal elements may be carried out by either a dry mixing method or a wet mixing method, and a method capable of uniformly mixing compounds containing metal elements is preferably carried out, and in this case, examples of the mixing apparatus include apparatuses such as a ball mill, a V-shaped mixer, a vibration mill, an attritor, a dino mill and a dynamic mill.

In calcination of a metal compound mixture, a calcining temperature, a calcining atmosphere and a calcining retention time may be appropriately set so as to yield the intended manganese-based oxide. Examples of the calcination conditions include calcination conditions of heating up to a calcining temperature of from 600°C to 1000°C in air and keeping for 0 to 24 hours.

Further using copper oxide, the said manganese-based oxide and copper oxide are mixed to yield a mixture so that the ratio of the molar amount of copper to one mol of manganese is in the range of from 0.001 to 0.05 in the mixture of a manganese-based oxide and copper oxide, and the mixture is sintered at a temperature within the range of from 900°C to 1200°C, whereby a sintered body can be obtained. As the sintering atmosphere, an oxidizing atmosphere is preferable. This atmosphere preferably includes an air atmosphere or an atmosphere containing oxygen in an amount of 20 vol% or more. The atmosphere containing oxygen in an amount of 20 vol% or more includes an oxygen atmosphere, and a mixed gas atmosphere of oxygen-inert gas (oxygen-nitrogen, oxygen-argon, and the like). By changing the oxygen concentration, it is possible to control the oxygen amount in a manganese-based oxide. It is also possible, after sintering in an inert atmosphere, to perform annealing in an atmosphere containing oxygen, thereby controlling the oxygen amount. The inert atmosphere includes an atmosphere composed of an inert gas such as nitrogen and argon. The inert atmosphere may contain oxygen in an approximate amount not generating an oxidizing atmosphere (for example, the oxygen concentration is less than about 20 vol%). It is also possible, after sintering in such an inert atmosphere, to perform annealing in an oxidizing atmosphere, thereby controlling the oxygen amount in a sintered body. Moreover, the resultant sintered body may be pulverized, and sintering may be carried out again using the pulverized substance. After heating up to the sintering temperature, the retention time is usually about 0 to 50 hours. When the sintering temperature is less than 900°C, a sintered body is not obtained easily in some cases, and when the sintering temperature is over 1200°C, a sintered body is not formed easily in some cases because of elution of CuO.

Particularly when the manganese-based oxide further contains calcium, namely, when the manganese-based oxide is a calcium manganese oxide, the preferable sintering temperature is within the range of from 950°C to 1100°C. In conventional technologies, $CaMnO_3$ is sintered at a high temperature over 1200°C in many cases, while in the present invention, a sintered body can be obtained at a relatively low sintering temperature within the range of from 900°C to 1200°C.

The above-described sintering is preferably performed after molding the above-described mixture of a manganese-based oxide and copper oxide. By sintering a molded body obtained by molding, the uniformity of the composition of the resultant sintered body and the uniformity of the structure of the sintered body can be improved, and the deformation of the sintered body can be suppressed, in some cases.

It may also be permissible that the above-described mixture of a manganese-based oxide and copper oxide is, for example, thermally treated in an oxidizing atmosphere (here, the thermal treatment temperature is a temperature lower than the sintering temperature), and the resultant powder is molded to yield a molded body, and the molded body is sintered in an oxidizing atmosphere.
By this, the uniformity of the composition of the resultant sintered body and the uniformity of the structure of the sintered body can be improved, and the deformation of the sintered body can be suppressed, in some cases.

The above-described mixture of a manganese-based oxide and copper oxide may also be produced by calcining a mixture of the above-described metal compound mixture and copper oxide. Namely, a sintered body can also be produced by a method in which copper oxide and a metal compound mixture which can become a manganese-based oxide by calcination are mixed, and the resultant mixture is, for example, heated up to a calcining temperature (here, the calcining temperature is lower than the sintering temperature) in an oxidizing atmosphere and calcined to yield powder which is then molded to yield a molded body, and the molded body is heated up to the sintering temperature in an oxidizing atmosphere and sintered. By this, the uniformity of the composition of the resultant sintered body and the uniformity of the structure of the sintered body can be improved, and the deformation of the sintered body can be suppressed, in some cases. The atmosphere for the above-described thermal treatment and calcination may be an inert atmosphere or reducing atmosphere. In this case, calcination may also be carried out again in an oxidizing atmosphere after the calcination. While sintering to be carried out after calcination, the oxygen concentration of its atmosphere may also be controlled.

Specifically, for example, in the case of obtaining the above-described mixture of $CaMnO_3$ and CuO, the mixture of $CaMnO_3$ and CuO can also be obtained by calcining a mixture of CuO and a metal compound mixture which can become $CaMnO_3$ by calcination. The calcination conditions in this case include calcination conditions of keeping for 0 to 24 hours in an oxidizing atmosphere at a calcining temperature of from 600°C to 1000°C.

The manganese-based oxide can be produced by the above-described method. Mentioned as other production methods are a method having a co-precipitation step, a method having a hydrothermal step, a method having a dry up step, a method having a sol gel step, and the like.

In the above-described methods, thermal treatment conditions such as a thermal treatment temperature, a thermal treatment atmosphere and a thermal treatment temperature retention time, and calcination conditions such as a calcining temperature, a calcining atmosphere and a calcining temperature retention time, may be appropriately set depending on the kind of the manganese-based oxide.

Mixing of the manganese-based oxide and copper oxide may be carried out by either a dry mixing method or a wet mixing method, and a method capable of performing more uniform mixing is preferable, and in this case, examples of the mixing apparatus include apparatuses such as a ball mill, a V-shaped mixer, a vibration mill, an attritor, a dino mill and a dynamic mill. Further, the mixing may be accompanied by pulverization.

The above-described molding may be performed so as to give a shape suitable as a thermoelectric converting device such as a plate shape, a rectangular cylinder shape and a circular cylinder shape. The molding method can be carried out, for example, by a uniaxial press, a cold isostatic press (CIP), a mechanical press, a hot press and a hot isostatic press (HIP). The mechanical strength of a sintered body can be further improved in some cases by performing a cold isostatic press (CIP) after a uniaxial press, in comparison with molding only by a uniaxial press. The molded body may contain a binder, a dispersant, a releasing agent and the like.

In sintering, it is also possible to carry out pressure sintering using a hot press, a pulse current sintering method and the like, in addition to normal pressure sintering.

Further, it may also be permissible that a sintered body obtained as described above is pulverized, and sintering as described above is carried out again using the pulverized substance.

The sintered body obtained as described above is excellent in mechanical strength. It is excellent also in thermal shock resistance, and moreover, when the sintered body is a thermoelectric conversion material, its thermoelectric converting property is not deteriorated, thus, the present invention is very useful for production of a thermoelectric conversion material. For production of a thermoelectric converting device using the resultant thermoelectric conversion material, a known technology as disclosed in, for example, JP-A No. 5-315657 may be used. In a thermoelectric converting device, a p-type thermoelectric conversion material and an n-type thermoelectric conversion material may be used in combination, and it may also be permissible that the resultant thermoelectric conversion material is used in any one of a p-type thermoelectric conversion material and an n-type thermoelectric conversion material and a known technology is used in another material.

The efficiency of converting thermal energy into electric energy of a thermoelectric conversion material (hereinafter, referred to as "energy conversion efficiency" in some cases) depends on the value (Z) of the performance index of a thermoelectric conversion material. The value (Z) of the performance index is a value determined according to the following formula (2) using the value ($\alpha$) of the Seebeck coefficient, the value ($\sigma$) of the electric conductivity and the value ($\kappa$) of the thermal conductivity of a thermoelectric conversion material. A thermoelectric conversion material having larger value (Z) of the performance index is said to be a thermoelectric converting device excellent in energy conversion efficiency. Particularly, $\alpha^2 \times \sigma$ in the formula (2) is called power factor (PF), and a thermoelectric conversion material having larger its value is said to be thermoelectric converting device excellent in output per unit temperature.

$$Z = \alpha^2 \times \sigma / \kappa \quad (2)$$

Here, the unit of Z is 1/K, the units of $\alpha$ is V/K, the unit of $\sigma$ is S/m and the unit of $\kappa$ is W/(m·K).

EXAMPLES

The present invention will be illustrated further in detail by examples below. For evaluation of the property and structure of a thermoelectric conversion material, methods shown below were used.

1. Electric conductivity ($\sigma$)

A sintered body specimen was processed into a rectangular cylinder shape, a platinum line was bonded thereto with a silver paste, and the value ($\sigma$) of the electric conductivity was measured by a direct current four-terminal method. The measurement was carried out while changing the temperature in the range from room temperature to 1073 K in a nitrogen gas flow. The unit of $\sigma$ was S/m.

2. Seebeck coefficient ($\alpha$)

A R thermo couple (composed of platinum-rhodium line and platinum line) was, with a silver paste, bonded on the both end surfaces of a sintered body specimen processed into the same shape as in measurement of electric conductivity, and the temperatures of the both end surfaces of the sintered body specimen and thermoelectromotive forces were measured. The measurement was carried out while changing the temperature in the range from room temperature to 1073 K in a nitrogen gas flow. A glass tube in which air was flowing was allowed to contact the one end surface of the sintered body specimen to make a low temperature part, the temperatures of the both end surfaces of the sintered body specimen were measured by a R thermo couple, and simultaneously, the thermoelectromotive force ($\Delta V$) generated between the both end surfaces of the sintered body specimen was measured by a platinum line of the R thermo couple. The temperature difference ($\Delta T$) between the both ends of the sintered body specimen was controlled in the range of 1 to 10°C by controlling the flow rate of air flowing in the glass tube, and the value ($\alpha$) of Seebeck coefficient was determined from the inclinations of $\Delta T$ and $\Delta V$. The unit of $\alpha$ was $\mu$V/K.

3. Power factor (PF)

The value of PF was determined according to the following formula from the above-described values of $\sigma$, $\alpha$.

$$PF = \alpha^2 \times \sigma$$

Here, the unit of PF is W/(m·K$^2$).

4. Structure analysis

The crystal structure of thermally treated articles and sintered body specimens was analyzed by a powder X-ray diffraction method using CuK$\alpha$ as a radiation source, using an X-ray diffractometer RINT2500TTR type manufactured by Rigaku Corporation.

5. Bending strength

A rod-shaped sintered body having a width (w) of 4$\pm$1 mm, a thickness (t) of 3$\pm$1 mm and a length of 36 mm or more was fabricated, and a three point bending test was carried out using SHIKIBU manufactured by Shimadzu Corp. A distance (L) between supporting points was 30 mm, and the cross head speed was 0.5 mm/min.
Bending strength ($\delta$) was determined according to the following formula.

$$\delta = 3PL/2wt^2$$

(P represents maximum load (N) in breaking of a specimen piece, and the unit of $\delta$ is N/ mm$^2$).
Seven or more samples were measured for each specimen and data was determined, and the average value ($\delta_{ave}$) was determined excluding the maximum data and the minimum data.

Example 1

CaCO$_3$ (manufactured by Ube Material Industries, CS3N-A (trade name)) of 8.577 g, MnO$_2$ (manufactured by Kojundo Chemical Laboratory) of 7.852 g, MoO$_3$ (manufactured by Kojundo Chemical Laboratory) of 0.247 g and CuO (manufactured by Kojundo Chemical Laboratory) of 0.359 g were weighed out (the ratio of the molar amount of copper to one mol of manganese was 0.05), and mixed for 20 hours by a wet ball mill using zirconia balls, and calcined by keeping at 900°C for 10 hours in air to yield a mixture of a manganese-based oxide and copper oxide, and this mixture was pulverized for 20 hours by a wet ball mill using zirconia balls, and molded into a rod shape by a uniaxial press (molding pressure: 500 kg/cm$^2$), and the resultant molded body was sintered by keeping at 1050°C for 10 hours in air to yield Sintered body 1.
Regarding the property of Sintered body 1, the Seebeck coefficient measured at 673 K was -150 ($\mu$V/K), the electric conductivity measured at 673 K was 1.1$\times$10$^4$ (S/m), and the power factor was determined to be 2.5$\times$10$^{-4}$ (W/mK$^2$). The average value ($\delta_{ave}$) of the bending strength in a three point bending test of Sintered body 1 was 583, the average value of Sintered body 2 in Comparative Example 1 being 100. The relative density of Sintered body 1 was 97.4%.

Comparative Example 1

A molded body was fabricated in the same manner as in Example 1 excepting that the CuO was not used (the ratio of the molar amount of copper to one mol of manganese was 0), and the resultant molded body was sintered by keeping at 1300°C for 10 hours in air to fabricate Sintered body 2.
Regarding the property of Sintered body 2, the Seebeck coefficient measured at 673 K was -139 ($\mu$V/K), the electric conductivity measured at 673 K was 4.9$\times$10$^3$ (S/m), and the power factor was determined to be 9.5$\times$10$^{-5}$ (W/mK$^2$). The average value ($\delta_{ave}$) of the bending strength in a three point bending test of Sintered body 2 was 100. The relative density of Sintered body 2 was 96.0%.

Comparative Example 2

Sintered body 3 was fabricated in the same manner as in Comparative example 1 excepting that sintering was performed by keeping at 1050°C for 10 hours. Sintered body 3 was fractured easily, teaching small mechanical strength.

Example 2

A molded body was fabricated in the same manner as in Example 1, and the molded body was subjected to a CIP treatment (pressure: 1000 kg/cm$^2$), then, the resultant molded body was sintered by keeping at 1050°C for 10 hours in atmospheric air to fabricate Sintered body 4.

The average value ($\delta_{ave}$) of the bending strength in a three point bending test of Sintered body 4 was 655, the average value of Sintered body 2 in Comparative Example 1 being 100.

Example 3

Sintered body 5 was fabricated in the same manner as in Example 2 excepting that the sintering temperature was 1000°C. Regarding the property of Sintered body 5, the Seebeck coefficient measured at 673 K was -203 ($\mu$V/K), the electric conductivity measured at 673 K was $5.9\times10^3$ (S/m), and the power factor was determined to be $2.5\times10^{-4}$ (W/mK$^2$). The average value ($\delta_{ave}$) of the bending strength in a three point bending test of Sintered body 5 was 659, the average value of Sintered body 2 in Comparative Example 1 being 100. The relative density of Sintered body 5 was 95.0%.

Example 4

Sintered body 6 was fabricated in the same manner as in Example 2 excepting that the sintering temperature was 980°C. Regarding the property of Sintered body 6, the Seebeck coefficient measured at 673 K was -163 ($\mu$V/K), the electric conductivity measured at 673 K was $5.0\times10^3$ (S/m), and the power factor was determined to be $1.3\times10^{-4}$ (W/mK$^2$). The average value ($\delta_{ave}$) of the bending strength in a three point bending test of Sintered body 6 was 376, the average value of Sintered body 2 in Comparative Example 1 being 100. The relative density of Sintered body 6 was 86.6%.

Example 5

Sintered body 7 was fabricated in the same manner as in Example 2 excepting that the sintering temperature was 1200°C. Sintered body 7 had the same mechanical strength as that in Example 2.

Example 6

Sintered body 8 was fabricated in the same manner as in Example 2 excepting that a mixture of a manganese-based oxide and copper oxide was obtained at a use amount of copper oxide (CuO) of 0.069 g (the ratio of the molar amount of copper to one mol of manganese was 0.01).
Regarding the property of Sintered body 8, the Seebeck coefficient measured at 673 K was -153 ($\mu$V/K), the electric conductivity measured at 673 K was $1.0\times10^4$ (S/m), and the power factor was determined to be $2.5\times10^{-4}$ (W/mK$^2$). The average value ($\delta_{ave}$) of the bending strength in a three point bending test of Sintered body 8 was 845, the average value of Sintered body 2 in Comparative Example 1 being 100. The relative density of Sintered body 8 was 95.0%.

Example 7

Sintered body 9 was fabricated in the same manner as in Example 1 excepting that the sintering atmosphere was an atmosphere having an oxygen concentration of 99 vol% or more. Sintered body 9 had the same mechanical strength as that in Example 1.
Sintered bodies 1 to 9 described above were subjected to measurement of powder X-ray diffraction. In all of them, the sintered body had the same type crystal structure as the perovskite type crystal of $CaMnO_3$, and other crystal structures were not detected, indicating that a calcium manganese oxide having a perovskite type crystal structure is a main component.

INDUSTRIAL APPLICABILITY

According to the present invention, a sintered body excellent in mechanical strength as compared with conventional manganese-based oxide sintered bodies can be provided. Additionally, a sintered body can be obtained by sintering at lower temperature than conventional temperatures.
The sintered body obtained by the present invention is excellent also in thermal shock resistance, and further, as a thermoelectric conversion material, its thermoelectric converting property is not deteriorated as compared with conventional materials, thus, a thermoelectric converting device having a thermoelectric conversion material composed of this sintered body can be suitably used for thermoelectric converting electric generation utilizing waste heat of factories, waste heat of incinerators, waste heat of factory furnaces, waste heat of automobiles, underground heat, solar heat and the like, and can also be used for precise temperature controlling apparatuses for laser diodes and the like, air conditioning equipments, refrigerators and the like. The sintered body obtained by the present invention can be used also for solid oxides for fuel cells, magnetic materials, and the like, in addition to thermoelectric conversion materials.

**Claims**

1. A production method of a sintered body, comprising a step of sintering, at a temperature within the range of from 900°C to 1200°C, a mixture of a manganese-based oxide and copper oxide wherein the ratio of the molar amount of copper to one mol of manganese in the mixture is in the range of from 0.001 to 0.05.

2. The production method according to Claim 1, wherein the sintering is performed after molding of the mixture.

3. The production method according to Claim 1 or 2, wherein the manganese-based oxide has a perovskite type crystal structure or a layered perovskite type crystal structure.

4. The production method according to any one of Claims 1 to 3, wherein the manganese-based oxide is a calcium manganese oxide.

5. The production method according to any one of Claims 1 to 4, wherein the sintered body is a sintered body to be used as a thermoelectric conversion material.

# INTERNATIONAL SEARCH REPORT

| | International application No. |
|---|---|
| | PCT/JP2009/052242 |

A. CLASSIFICATION OF SUBJECT MATTER
*C04B35/00*(2006.01)i, *H01L35/22*(2006.01)i, *H01L35/34*(2006.01)i

According to International Patent Classification (IPC) or to both national classification and IPC

B. FIELDS SEARCHED

Minimum documentation searched (classification system followed by classification symbols)
C04B35/00, H01L35/22, H01L35/34

Documentation searched other than minimum documentation to the extent that such documents are included in the fields searched
Jitsuyo Shinan Koho      1922-1996   Jitsuyo Shinan Toroku Koho   1996-2009
Kokai Jitsuyo Shinan Koho   1971-2009   Toroku Jitsuyo Shinan Koho   1994-2009

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X | JP 2005-51103 A  (Japan Science and Technology Agency), 24 February, 2005 (24.02.05), Claims; example 2; Par. No. [0030] (Family: none) | 1-5 |
| A | WO 2006/109884 A1  (Sumitomo Chemical Co., Ltd.), 19 October, 2006 (19.10.06), Claims & JP 2006-294960 A     & EP 1895603 A1 & KR 10-2008-0003875 A   & CN 101156256 A | 1-5 |
| P,X | WO 2008/047885 A1  (Sumitomo Chemical Co., Ltd.), 24 April, 2008 (24.04.08), Claims; example 6 & JP 2008-124417 A | 1-5 |

[X] Further documents are listed in the continuation of Box C.     [ ] See patent family annex.

| | | |
|---|---|---|
| * | Special categories of cited documents: | "T" later document published after the international filing date or priority date and not in conflict with the application but cited to understand the principle or theory underlying the invention |
| "A" | document defining the general state of the art which is not considered   to be of particular relevance | |
| "E" | earlier application or patent but published on or after the international filing date | "X" document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" | document referring to an oral disclosure, use, exhibition or other means | |
| "P" | document published prior to the international filing date but later than the priority date claimed | "&" document member of the same patent family |

| Date of the actual completion of the international search | Date of mailing of the international search report |
|---|---|
| 09 April, 2009 (09.04.09) | 21 April, 2009 (21.04.09) |

| Name and mailing address of the ISA/ | Authorized officer |
|---|---|
| Japanese Patent Office | |
| Facsimile No. | Telephone No. |

Form PCT/ISA/210 (second sheet) (April 2007)

**INTERNATIONAL SEARCH REPORT**

| International application No. |
| --- |
| PCT/JP2009/052242 |

C (Continuation). DOCUMENTS CONSIDERED TO BE RELEVANT

| Category* | Citation of document, with indication, where appropriate, of the relevant passages | Relevant to claim No. |
| --- | --- | --- |
| A | JP 2003-142742 A (Toyota Central Research and Development Laboratories, Inc.), 16 May, 2003 (16.05.03), Claims; Par. Nos. [0031], [0059] (Family: none) | 1-5 |
| A | JP 2007-335504 A (Sumitomo Chemical Co., Ltd.), 27 December, 2007 (27.12.07), Claims; Par. Nos. [0014], [0027] (Family: none) | 1-5 |

Form PCT/ISA/210 (continuation of second sheet) (April 2007)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2003142742 A

- JP 5315657 A